# EUROPEAN PATENT APPLICATION

(11) **EP 1 881 746 A2**
(43) Date of publication of application: **23.01.2008**
(21) Application number: 07005502.5
(22) Date of filing: 16.03.2007
(51) Int. Cl.: H05K 1/02

(54) **Cooling device for light emitting diode (LED) module and method for fabricating the same**

(30) Priority: 19.07.2006 KR 20060067250
(71) Applicant: Alti-electronics Co., Ltd., Cheoin-gu, Yongin-si, Gyeonggi-do (KR)
(72) Inventor: Kim, Dong Soo, Ansan-si Gyeonggi-do (KR)
(74) Representative: Grünecker, Kinkeldey, Stockmair & Schwanhäusser Anwaltssozietät

(57) **Abstract**

A cooling device of a light emitting diode module and a method for fabricating the same are disclosed. According to the cooling device for a light emitting diode module of the present invention, the thickness of the whole module is reduced, a thermal resistance is small since a final heat-releasing path from a heat source is shortened, it is easy to release heat, and processing efficiency is high and manufacturing cost is low because a bending process of a lead frame is removed.

## Description

### CROSS-REFERENCE TO RELATED APPLICATION

This application claims priority to and the benefit of Korean Patent Application No. 10-2006-67250, filed July 19, 2006, the disclosure of which is incorporated herein by reference in its entirety.

### BACKGROUND OF THE INVENTION

### 1. Field of the Invention

The present invention relates to a cooling device for a light emitting diode ("LED") and method for fabricating the same and, more particularly, to a cooling device for an LED module in which the thickness of the whole module is reduced, a thermal resistance is small since a final heat-releasing path from a heat source is shortened, it is easy to release heat, and processing efficiency is high and manufacturing cost is low because a bending process of a lead frame is removed and method for fabricating the same.

### 2. Description of the Related Art

An LED emits light when a voltage is applied thereto and is usually employed in a lighting device or a backlight unit of a liquid crystal display ("LCD") due to advantages such as a long lifespan, an environment-friendly characteristic and a fast response speed. Such an LED generates heat because it is a self-light emitting, and thus an LED module needs a cooling device for releasing the generated heat.

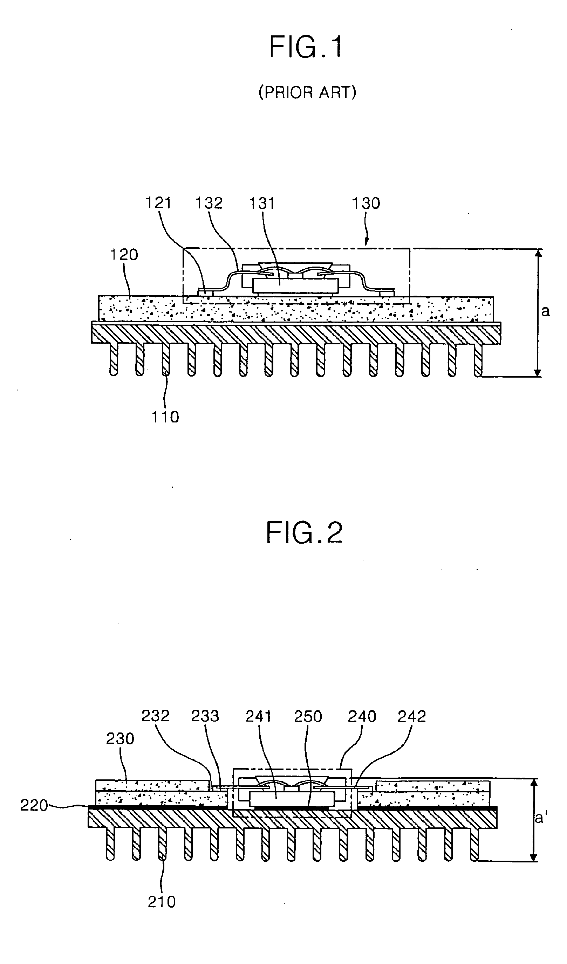

FIG. 1 is a cross-sectional view illustrating a cooling device of a LED module according to a conventional art.

Referring to FIG. 1, heat generated in an LED module is released through a metal core ("MC") printed circuit board ("PCB") having an electrode pattern formed thereon.

An MC PCB 120 having a solder pad 121 is mounted on a heat releasing substrate 110. The heat releasing substrate 110 and the MC PCB 120 are attached by using a thermal pad. An LED package 130 is mounted on the MC PCB 120.

The LED package 130 comprises a lead frame 132 connected to the solder pad 121 of the MC PCB 120 and a heat slug 131 arranged on its lower portion for efficient heat releasing. The heat slug 131 and the MC PCB 120 are attached by soldering or thermal grease.

However, the cooling device of the LED module of FIG. 1 uses the MC PCB and thermal pad which are high-priced, and so its manufacturing cost is high.

The thickness of the whole module is thick since the LED package is mounted on the MC PCB. In particular, when the LED module is used as the backlight unit of the LCD device, there is a problem for minimizing a distance between a light source and an optical sheet.

In addition, in case of a chip on board ("COB") type in which an LED chip is attached directly to an LED, it is not easy to repair a single-unit LED package, and since the MC PCB directly contacts the heat slug, conduction of heat to the chip is accelerated when the LED is solder-mounted on the PCB, whereby reliability of the chip is low.

### SUMMARY OF THE INVENTION

It is an object of the present invention to provide a cooling device of an LED module in which a thickness competitive power is obtained by reducing the thickness of the whole module, a thermal resistance is small by shortening a final heat releasing path from a heat source, and it is easy to release heat and a method for fabricating the same.

It is another object of the present invention to provide a cooling device of an LED module in which a manufacturing cost is low since the MC PCB and the thermal pad which are high-priced are substituted, the weight of the whole module is light, and the adhering flatness of the PCB is excellent and a method for fabricating the same.

It is yet another object of the present invention to provide a cooling device of an LED module in which processing efficiency and productivity are improved and the manufacturing process is simplified since the LED package is mounted without using the bending process of the lead frame of the LED, and deterioration of the chip is prevented since the heat releasing substrate does not contact the PCB during the high temperature reflow process and a method for fabricating the same.

It is still another object of the present invention to provide a cooling device of an LED module in which heat is transferred to the heat releasing substrate through the lead frame when the LED package does not include the heat slug and a method for fabricating the same.

One aspect of the present invention provides a cooling device of an LED module, comprising: a heat releasing substrate for releasing heat; a PCB mounted on the heat releasing substrate and including a penetrated portion and an electrode pad; and an LED package inserted through the penetrated portion of the PCB to be mounted.

Another aspect of the present invention provides a cooling device of an LED module, comprising: a PCB having an electrode pad and a penetrated portion; an LED package inserted through the penetrated portion in a state that the PCB is overturned; and a heat releasing substrate attached to a bottom surface of the mounted PCB.

One aspect of the present invention provides a method for fabricating a cooling device of an LED module, comprising: fabricating a PCB having a penetrated portion and an electrode pad; mounting an LED package by inserting the LED package through the penetrated portion; and attaching the PCB to a heat releasing substrate.

Another aspect of the present invention provides a method for fabricating a cooling device of an LED module, comprising: fabricating a PCB having a penetrated portion and an electrode pad; mounting an LED package by overturning the PCB and inserting the LED package through the penetrated portion; and attaching the PCB to a heat releasing substrate.

### BRIEF DESCRIPTION OF THE DRAWINGS

The above and other features of the present invention will be described in reference to certain exemplary embodiments thereof with reference to the attached drawings in which:
FIG. 1 is a cross-sectional view illustrating a cooling device of a LED module according to a conventional art;
FIG. 2 is a cross-sectional view illustrating a cooling device of an LED module according to one exemplary embodiment of the present invention;
FIG. 3 is a plane view illustrating a PCB for the cooling device of the LED module according to the present invention;
FIG. 4 is a cross-sectional view illustrating a cooling device of an LED module according to another exemplary embodiment of the present invention; and
FIGS. 5A, 5B, and 5C show a device and temperature distributions for comparing heat releasing effects of the conventional cooling device of the LED module and the inventive cooling device of the LED module.

### DETAILED DESCRIPTION OF THE INVENTION

Reference will now be made in detail to the embodiments of the present invention, examples of which are illustrated in the accompanying drawings, wherein like reference numerals refer to the like elements throughout. The embodiments are described below in order to explain the present invention by referring to the figures.

FIG. 2 is a cross-sectional view illustrating a cooling device of an LED module according to one exemplary embodiment of the present invention.

Referring to FIG. 2, the cooling device of the LED module comprises a heat releasing substrate 210 for releasing heat generated from an LED, a PCB substrate 230 which is mounted on the heat releasing substrate 210 and includes an electrode pad 233 and a penetrated portion 231 in which an LED package 240 is mounted, and the LED package 240 mounted on the heat releasing substrate 210 through the penetrated portion 231 of the PCB 230.

The LED package 240 comprises an LED chip for emitting light, a lead frame 242 soldered to the electrode pad 233 for electrical contact of the LED chip, and a heat slug 241 arranged on its lower portion for efficient heat releasing. The heat slug 241 may be made of aluminum (Al), copper (Cu) or molybdenum (Mo).

The heat releasing substrate 210 and the PCB 230 are attached by an adhering means 220. As the adhering means 220, a thermal pad may be used to obtain heat endurance, and a heat resistant double-sided tape which is low in price may be used.

Alternatively, as the adhering means 220, a thin insulating adhesive, a soldering, or a thermal grease may be used.

The heat releasing substrate 210 is made of a material for releasing heat generated from an LED. A heat sink or heat plate may be used as the heat releasing substrate 210.

The PCB 230 is made of a material for releasing heat. As the PCB 230, the MC PCB may be used, but in order to reduce a manufacturing cost, a bismaleimide triazine (BT) or FR4 PCB may be used. FR4 can promote adhering flatness due to its flexibility.

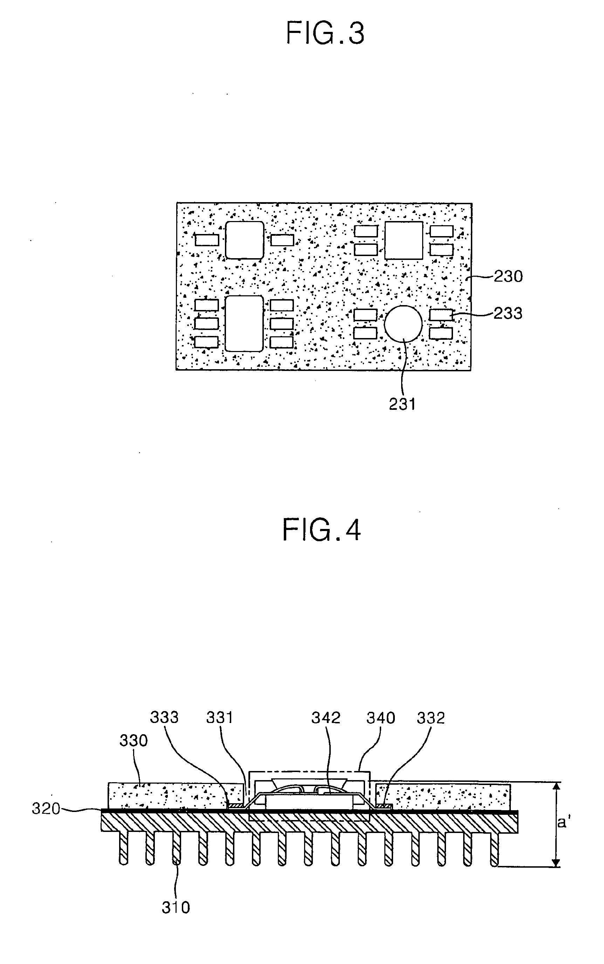

FIG. 3 is a plane view illustrating the PCB for the cooling device of the LED module according to the present invention.

Referring to FIG. 3, the shape and size of the penetrated portion 231 of the PCB 230 depend on the shape and size of the LED package 240. The penetrated portion 231 of the PCB 230 may have various shapes such as a quadrangle, a circle, and an ellipse and various sizes.

A location and number of the electrode pad 233 formed on the PCB 230 depend on a location and number of the lead frame 242 of the LED package 240. That is, a location and number of the electrode pad 233 (i.e., electrode pattern) formed on the PCB 230 are designed in light of a location of number of the lead frame 242 of the LED package 240.

A groove 232 is formed on a portion of the PCB 230, and the electrode pad 233 is mounted on the groove 232.

The depth of the groove 232 is designed such that the electrode pad 233 mounted in the groove 232 is equal in height to the lead frame 242 of the LED package 240 mounted through the penetrated portion 231 of the PCB 230. This makes the LED package 240 mounted without using a process for bending the lead frame 242.

FIG. 4 is a cross-sectional view illustrating a cooling device of an LED module according to another exemplary embodiment of the present invention.

The cooling device of the LED module of FIG 4 is different from that of FIG. 2 in the fact that an LED package does not include a heat slug and an electrode pad 333 is located on a bottom surface of a PCB 330 which is overturned.

In the cooling device of the LED module of FIG. 2, the lead frame 242 of the LED package 240 is soldered to the electrode pad 233 on a top surface of the PCB 230, whereas in the cooling device of the LED module of FIG. 4, the LED package 240 is mounted in the overturned PCB 330, and so the lead frame 342 is soldered to the electrode pad 333 on a bottom surface of the PCB 330 and contacts a heat releasing substrate 310 through an adhering means 320. Thus, even though the LED package 340 does not include a heat slug, most heat generated in the LED package 340 is transferred to the heat releasing substrate 310 through the lead frame 342, thereby improving the heat releasing effect.

A method for fabricating the cooling device of the LED module according to one exemplary embodiment of the present invention is described below.

First, the PCB 230 having the penetrated portion 231 and the electrode pad 233 is fabricated. The penetrated portion 231 may be formed by using a punching technique according to the shape and size of the LED package 240.

The groove 232 is formed in a portion of the PCB 230 on which the electrode pad 233 is to be formed. The electrode pad 233 is mounted on the groove 232 to form an electrode pattern.

The depth of the groove 232 formed in the PCB 230 is determined in light of the height of the lead frame 242 of the LED package 240 to be mounted. The height of the electrode pad 233 mounted in the groove 232 is designed to be equal to the height of the lead frame 242.

Then, the LED package 240 is mounted such that it is inserted through the penetrated portion 231 of the PCB 230. As a technique for mounting the LED package 240, a surface mounted technology (SMT) may be used.

In case where the LED package 240 includes the heat slug 241, the heat slug 241 is attached directly to the heat releasing substrate 210, thereby improving a heat releasing performance. As the adhering means for adhering the heat slug 241 and the heat releasing substrate 210, a soldering or a thermal grease may be used.

In case where the LED package 240 does not include the heat slug 241, the electrode pattern is formed on the PCB 230, and a bottom surface of the LED package 240 is attached directly to the heat releasing substrate 210, thereby improving heat releasing efficiency.

Since the electrode pad 233 is designed and formed to be equal in height to the lead frame 242, the bending process for connecting the lead frame 242 to the electrode pad 233 is not required when the LED package 240 is mounted, whereby the manufacturing process is simplified.

During a high temperature reflow process for a soldering for mounting the LED package 240, the LED chip rarely deteriorates since the PCB 230 and the heat slug 241 directly contact each other, leading to a high thermal reliability.

Thereafter, the PCB 230 in which the LED package 240 is mounted is attached to the heat releasing substrate 210. As the adhering means for attaching the PCB 230 and the heat releasing substrate 210, a heat resistant double-sided tape may be used.

Next, a method for fabricating the cooling device of the LED module according to another exemplary embodiment of the present invention is described below.

First, the PCB 330 having the electrode pad 333 and the penetrated portion 331 in which the LED package 340 is to be mounted is fabricated.

Then, the LED package 340 is mounted such that it is inserted through the penetrated portion 331 of the PCB 330. As a technique for mounting the LED package 340, a surface mounted technology (SMT) may be used.

Here, the method for fabricating the PCB 330 is identical to that of one exemplary embodiment of the present invention described above, but it is different from one exemplary embodiment of the present invention in the fact that the overturned PCB 330 is used when the LED package 340 is mounted.

Thus, the LED package 340 is inserted through the penetrated portion 331 in a state that the PCB 330 is overturned, and the electrode pad 333 located on the bottom surface of the PCB 330 is soldered to the lead frame 342.

Through the above-described LED package mounting process, the lead frame 342 is formed below the electrode pad 333 formed on the bottom surface of the PCB 330.

Thereafter, the PCB 330 in which the LED package 340 is mounted is attached to the heat releasing substrate 310 by using the adhering means 320. At this time, since the heat releasing substrate 310 and the lead frame 342 of the LED package 340 are adhered by the adhering means 320, the lead frame 342 transfers heat generated in the LED chip to the heat releasing substrate 310, whereby the heat releasing effect is increased even though the heat slug is not used.

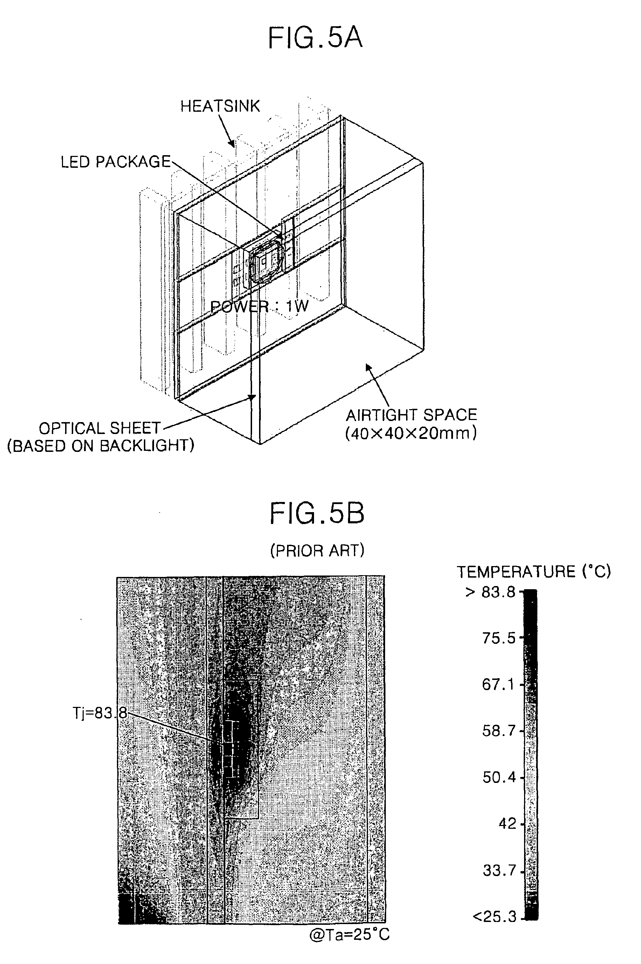

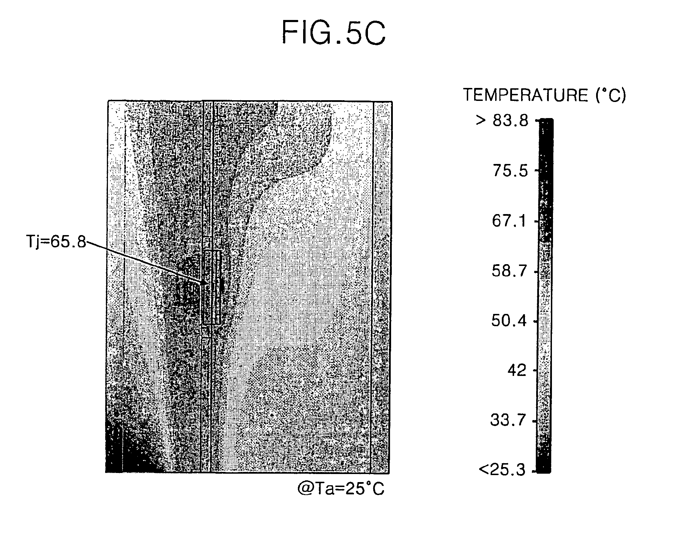

FIGS. 5A, 5B and 5C show a device and temperature distributions for comparing the heat releasing effects of the conventional cooling device of the LED module and the inventive cooling device of the LED module.

In order to verify the heat releasing effect of the cooling device of the LED module according to the present invention, an airtight space covered with an optical sheet was prepared as shown in FIG. 5A. The conventional cooling device of the LED module and the inventive cooling device of the LED module were respectively mounted in the airtight space, and a temperature around the LED package 240 of when an electrical power of the LED is 1 watt was measured.

A temperature around the conventional cooling device of the LED module was 83.5°C as shown in FIG. 5B, whereas a temperature around the inventive cooling device of the LED module was 65.8°C as shown in FIG. 5C. That is, it can be seen that the inventive cooling device of the LED module is more excellent in heat releasing effect that the conventional cooling device of the LED module.

As described above, according to the cooling device of the LED module and the method for fabricating the same of the present invention, a thickness competitive power is obtained since the thickness of the whole module is reduced, and also a heat resistance is small and it is easy to release heat since a final heat releasing path from a heat source is shortened.

In addition, the manufacturing cost is low since the MC PCB and the thermal pad which are high-priced are substituted, the processing efficiency and the productivity are improved and the manufacturing process is simplified since the LED package is mounted without using the bending process of the lead frame, and deterioration of the chip is prevented since the heat releasing substrate does not contact the MC PCB during the high temperature reflow process.

Although the present invention has been described with reference to certain exemplary embodiments thereof, it will be understood by those skilled in the art that a variety of modifications and variations may be made to the present invention without departing from the spirit or scope of the present invention defined in the appended claims, and their equivalents.

## Claims

1. A cooling device of a light emitting diode ("LED") module, comprising:
a heat releasing substrate for releasing heat;
a printed circuit board ("PCB") mounted on the heat releasing substrate and including a penetrated portion and an electrode pad; and
an LED package inserted through the penetrated portion of the PCB to be mounted.

2. The cooling device of the LED module of claim 1, wherein the heat releasing substrate and the LED package are attached by an heat resistant adhesive, a soldering or a thermal grease.

3. The cooling device of claim the LED module of claim 1, wherein the LED package comprises
an LED chip formed in the package; and
a lead frame soldered to the electrode pad formed on the PCB for electrical contact of the LED chip.

4. The cooling device of claim the LED module of claim 3, wherein the LED package further comprises a heat slug mounted below the LED chip to release heat to the heat releasing substrate.

5. The cooling device of claim the LED module of claim 1, wherein a shape and size of the penetrated portion of the PCB are designed corresponding to a shape and size of the LED package.

6. The cooling device of claim the LED module of claim 1, wherein a location and number of the electrode pad formed on the PCB are designed corresponding to a location and number of the lead frame of the LED package.

7. The cooling device of claim the LED module of claim 1, wherein the PCB comprises
a groove formed a portion on which the electrode pad is to be mounted; and
the electrode pad mounted in the groove.

8. The cooling device of claim the LED module of one of claim 1, wherein the heat releasing substrate and the PCB are attached by a heat resistant double-sided tape.

9. The cooling device of claim the LED module of one of claim 1, wherein the heat releasing substrate is either a heat sink or a heat plate.

10. The cooling device of claim the LED module of one of claim 1, wherein the PCB is either Bismaleimide Triazine (BT) or FR4 PCB.

11. A cooling device of a light emitting diode (LED) module, comprising:
a printed circuit board (PCB) having an electrode pad and a penetrated portion;
an LED package inserted through the penetrated portion in a state that the PCB is overturned; and
a heat releasing substrate attached to a bottom surface of the mounted PCB.

12. The cooling device of claim the LED module of claim 11, wherein the LED package comprises
an LED chip formed in the package; and
a lead frame soldered to the electrode pad formed on a bottom surface of the PCB for electrical contact of the LED chip and contact the heat releasing substrate through an adhering means.

13. The cooling device of claim the LED module of claim 11, wherein a shape and size of the penetrated portion of the PCB are designed corresponding to a shape and size of the LED package.

14. The cooling device of claim the LED module of claim 11, wherein a location and number of the electrode pad formed on the PCB are designed corresponding to a location and number of the lead frame of the LED package.

15. The cooling device of claim the LED module of claim 11, wherein the PCB comprises
a groove formed a portion on which the electrode pad is to be mounted; and
the electrode pad mounted in the groove.

16. The cooling device of claim the LED module of claim 15, wherein the depth of the groove is formed such that the electrode pad mounted in the groove is equal in height to the lead frame of the LED package mounted through the penetrated portion of the PCB.

17. The cooling device of claim the LED module of one of claim 11, wherein the heat releasing substrate and the PCB are attached by a heat resistant double-sided tape.

18. The cooling device of claim the LED module of one of claim 11, wherein the heat releasing substrate is either a heat sink or a heat plate.

19. The cooling device of claim the LED module of one of claim 11, wherein the PCB is either Bismaleimide Triazine (BT) or FR4 PCB.

20. A method for fabricating a cooling device of a light emitting diode (LED) module, comprising:
fabricating a printed circuit board (PCB) having a penetrated portion and an electrode pad;
mounting an LED package by inserting the LED package through the penetrated portion; and
attaching the PCB to a heat releasing substrate.

21. The method of claim 20, wherein the step of mounting the LED package further comprises soldering the electrode pad formed on the PCB to a lead frame of the LED package without using a bending process of the lead frame.

22. The method of claim 20, wherein the step of fabricating the PCB comprises forming a groove in a portion of the PCB in which the electrode pad is to be mounted.

23. The method of claim 20, wherein the step of fabricating the PCB comprises determining a shape of the penetrated portion according to a shape of the LED package and determining a location and number of the electrode pad according to a location and number of the lead frame.

24. The method of claim 20, wherein the depth of the groove is formed such that the electrode pad mounted in the groove is equal in height to the lead frame of the LED package mounted through the penetrated portion of the PCB.

25. A method for fabricating a cooling device of a light emitting diode (LED) module, comprising:
fabricating a printed circuit board (PCB) having a penetrated portion and an electrode pad;
mounting an LED package by overturning the PCB and inserting the LED package through the penetrated portion; and
attaching the PCB to a heat releasing substrate.

26. The method of claim 25, wherein the step of mounting the LED package further comprises soldering a lead frame of the LED package to a bottom surface of the electrode pad.

27. The method of claim 25, wherein the step for attaching the PCB comprises adhering a lead frame of the LED package to the heat releasing substrate by an adhering means.

28. The method of claim 25, wherein the step of fabricating the PCB comprises forming a groove in a portion of the PCB in which the electrode pad is to be mounted.

29. The method of claim 25, wherein the step of fabricating the PCB comprises determining a shape of the penetrated portion according to a shape of the LED package and determining a location and number of the electrode pad according to a location and number of the lead frame.

30. The method of claim 28, wherein the depth of the groove is formed such that the electrode pad mounted in the groove is equal in height to the lead frame of the LED package mounted through the penetrated portion of the PCB.
